# EUROPEAN PATENT APPLICATION

(11) **EP 4 439 782 A2**
(43) Date of publication of application: **02.10.2024**
(21) Application number: 24166239.4
(22) Date of filing: 26.03.2024
(51) Int. Cl.: H01M 10/42, H01M 10/48, H01M 50/209, H01M 50/284, H01M 50/519

(54) **BATTERY PACK AND METHOD OF MANUFACTURING THE SAME**

(30) Priority: 27.03.2023 KR 20230039738; 26.04.2023 KR 20230054965
(71) Applicant: Samsung SDI Co., Ltd., Yongin-si, Gyeonggi-do 17084 (KR)
(72) Inventor: Ahn, Jaepil, 17084 Yongin-si, Gyeonggi-do (KR); Kwon, Younghwan, 17084 Yongin-si, Gyeonggi-do, (KR); Lee, Hyeok, 17084 Yongin-si, Gyeonggi-do (KR); Yun, Chuljung, 17084 Yongin-si, Gyeonggi-do, (KR)
(74) Representative: Gulde & Partner

(57) **Abstract**

A battery pack, including a plurality of battery cells, and a state information transmission path for transmitting state information of the plurality of battery cells, wherein the state information transmission path includes a first circuit board unit including a first film layer and a first conductive layer formed over the first film layer,
a second circuit board unit including a second film layer and a (2-1)^{th} conductive layer and a (2-2)^{th} conductive layer formed on different surfaces of the second film layer, and
a conductive adhesive layer arranged between the first circuit board unit and the second circuit board unit to form an electrical connection therebetween.

## Description

### BACKGROUND

### 1. Field

One or more embodiments relate to a battery pack.

### 2. Description of the Related Art

In general, secondary batteries are rechargeable, unlike primary batteries that are not rechargeable. Secondary batteries are used as energy sources for mobile devices, electric vehicles, hybrid vehicles, electric bicycles, uninterruptible power supplies, and the like. The secondary batteries are used in the form of a single battery cell or in the form of a battery pack in which a plurality of battery cells are connected and packed into one unit, depending on the types of external devices to which they are applied.

### SUMMARY

The invention is defined by the appended claims. The description that follows is subjected to this limitation. Any disclosure lying outside the scope of said claims is only intended for illustrative as well as comparative purposes.

Embodiments are directed to a battery pack, including a plurality of battery cells, and a state information transmission path for transmitting state information of the plurality of battery cells, wherein the state information transmission path includes a first circuit board unit including a first film layer and a first conductive layer formed over the first film layer, a second circuit board unit including a second film layer and a (2-1)^{th} conductive layer and a (2-2)^{th} conductive layer formed on different surfaces of the second film layer, and a conductive adhesive layer arranged between the first circuit board unit and the second circuit board unit to form an electrical connection therebetween.

In embodiments the conductive adhesive layer may be arranged between the first conductive layer and the (2-2)^{th} conductive layer in an electrical connection direction of the first circuit board unit and the second circuit board unit.

In embodiments the second film layer may be formed on one side surface of the (2-1)^{th} conductive layer, and a third film layer may be formed on an other side surface of the (2-1)^{th} conductive layer. In other words, the second film layer may be formed on one side surface of the (2-1)^{th} conductive layer, and a third film layer may be formed on the opposing side surface of the (2-1)^{th} conductive layer.

In embodiments the (2-2)^{th} conductive layer and the second film layer may protrude more than the (2-1)^{th} conductive layer and the third film layer in a direction in which the first circuit board unit may be located.

In embodiments the first film layer may include a first cover unit covering the first film layer from an external space, the first cover unit may include a first recess portion formed with a lengthwise direction corresponding to a direction parallel to an electrical connection direction of the first circuit board unit and the second circuit board unit, and the first conductive layer may be accommodated in the first recess portion of the first cover unit.

In embodiments the first film layer may include a first cover unit covering the first film layer from an external space, the first cover unit may include a first recess portion formed with a lengthwise direction corresponding to a direction orthogonal to a stacking direction of the first circuit board unit and the second circuit board unit, and the first conductive layer may be accommodated in the first recess portion of the first cover unit.

In embodiments the (2-2)^{th} conductive layer may include a second cover unit covering the (2-2)^{th} conductive layer from an external space, the second cover unit may include a second recess portion formed with a lengthwise direction corresponding to a direction parallel to an electrical connection direction of the first circuit board unit and the second circuit board unit, and the conductive adhesive layer may be accommodated in the second recess portion of the second cover unit.

Embodiments are directed to a battery pack, including a plurality of battery cells, and a state information transmission path for transmitting state information of the plurality of battery cells, wherein the state information transmission path includes a first circuit board unit including a first film layer and a first conductive layer formed over the first film layer, a second circuit board unit including a second film layer and a (2-1)^{th} conductive layer and a (2-2)^{th} conductive layer formed on different surfaces of the second film layer, a conductive adhesive layer arranged between the first circuit board unit and the second circuit board unit to form an electrical connection therebetween, a first coating layer covering a longitudinal section of the first circuit board unit and a (1-1)^{th} step surface of the first circuit board unit and a (2-1)^{th} step surface of the second circuit board unit stepped from each other through the longitudinal section of the first circuit board unit, and a second coating layer covering a longitudinal section of the second circuit board unit and a (1-2)^{th} step surface of the first circuit board unit and a (2-2)^{th} step surface of the second circuit board unit stepped from each other through the longitudinal section of the second circuit board unit.

In embodiments the conductive adhesive layer and the first and second coating layers may be each formed through a single laminating process.

In embodiments the conductive adhesive layer may be arranged between the first conductive layer and the (2-2)^{th} conductive layer in an electrical connection direction of the first circuit board unit and the second circuit board unit.

In embodiments the second film layer may be formed on one side surface of the (2-1)^{th} conductive layer, and a third film layer may be formed on an other side surface of the (2-1)^{th} conductive layer. In other words, the second film layer may be formed on one side surface of the (2-1)^{th} conductive layer, and a third film layer may be formed on the opposing side surface of the (2-1)^{th} conductive layer.

In embodiments the (2-2)^{th} conductive layer and the second film layer may protrude more than the (2-1)^{th} conductive layer and the third film layer in a direction in which the first circuit board unit is located.

In embodiments the first film layer may include a first cover unit covering the first film layer from an external space, the first cover unit may include a first recess portion formed with a lengthwise direction corresponding to a direction parallel to an electrical connection direction of the first circuit board unit and the second circuit board unit, and the first conductive layer may be accommodated in the first recess portion of the first cover unit.

In embodiments the (2-2)^{th} conductive layer may include a second cover unit covering the (2-2)^{th} conductive layer from an external space, the second cover unit may include a second recess portion formed with a lengthwise direction corresponding to a direction parallel to an electrical connection direction of the first circuit board unit and the second circuit board unit, and the conductive adhesive layer may be accommodated in the second recess portion of the second cover unit.

Embodiments are directed to a method of manufacturing a battery pack, the method including arranging a conductive adhesive layer between a first circuit board unit including a first film layer and a first conductive layer formed over the first film layer and a second circuit board unit including a second film layer and a (2-1)^{th} conductive layer and a (2-2)^{th} conductive layer formed on different surfaces of the second film layer, stacking, on the first and second circuit board units, a first coating layer covering a longitudinal section of the first circuit board unit and a (1-1)^{th} step surface of the first circuit board unit and a (2-1)^{th} step surface of the second circuit board unit stepped from each other through the longitudinal section of the first circuit board unit, stacking a second coating layer covering a longitudinal section of the second circuit board unit and a (1-2)^{th} step surface of the first circuit board unit and a (2-2)^{th} step surface of the second circuit board unit stepped from each other through the longitudinal section of the second circuit board unit, and thermally compressing the first and second circuit board units, the conductive adhesive layer, and the first and second coating layers through a laminating process.

### BRIEF DESCRIPTION OF THE DRAWINGS

Features will become apparent to those of skill in the art by describing in detail exemplary embodiments with reference to the attached drawings in which:
FIG. 1 shows an exposed perspective view of a battery pack according to some embodiments of the present disclosure;
FIG. 2 is a schematic diagram of a circuit board unit and a connector according to some embodiments of the present disclosure;
FIG. 3 shows a front view of the circuit board unit of FIG. 2;
FIG. 4a shows a view of the circuit board unit of FIG. 2 in a direction A; FIG. 4b shows a view of the circuit board unit of FIG. 2 in a direction A1;
FIG. 5a shows a perspective view of a connection portion of FIG. 3; FIG. 5b shows a cross-sectional view of the connection portion of FIG. 3 taken along line E-E' of FIG. 5a;
FIG. 6 is a schematic diagram of a circuit board unit and a connector according to other embodiments of the present disclosure;
FIG. 7 shows a front view of the circuit board unit of FIG. 6;
FIG. 8a shows a view of the circuit board unit of FIG. 6 in a direction C; FIG. 8b shows a view of the circuit board unit of FIG. 6 in a direction D;
FIG. 9a shows a perspective view of a connection portion of FIG. 7; FIG. 9b shows a cross-sectional view of the connection portion of FIG. 7 taken along line F-F' of FIG. 9a; and
FIG. 10 is a flowchart showing a method of manufacturing a battery pack according to some embodiments of the present disclosure.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

As used herein, the term "and/or" includes any and all combinations of one or more of the associated listed items.

In describing the present disclosure, even when illustrated in different embodiments, like reference numerals are used for like elements.

It will be understood that although terms such as "first" and "second" may be used herein to describe various elements, these elements should not be limited by these terms and these terms are only used to distinguish one element from another element.

As used herein, the singular forms "a," "an," and "the" are intended to include the plural forms as well, unless the context clearly indicates otherwise.

It will be understood that terms such as "comprise," "include," and "have" used herein specify the presence of stated features or elements, but do not preclude the presence or addition of one or more other features or elements.

When a certain embodiment may be implemented differently, a particular process order may be performed differently from the described order. For example, two processes described in succession may be performed substantially at the same time or may be performed in an order opposite to the described order.

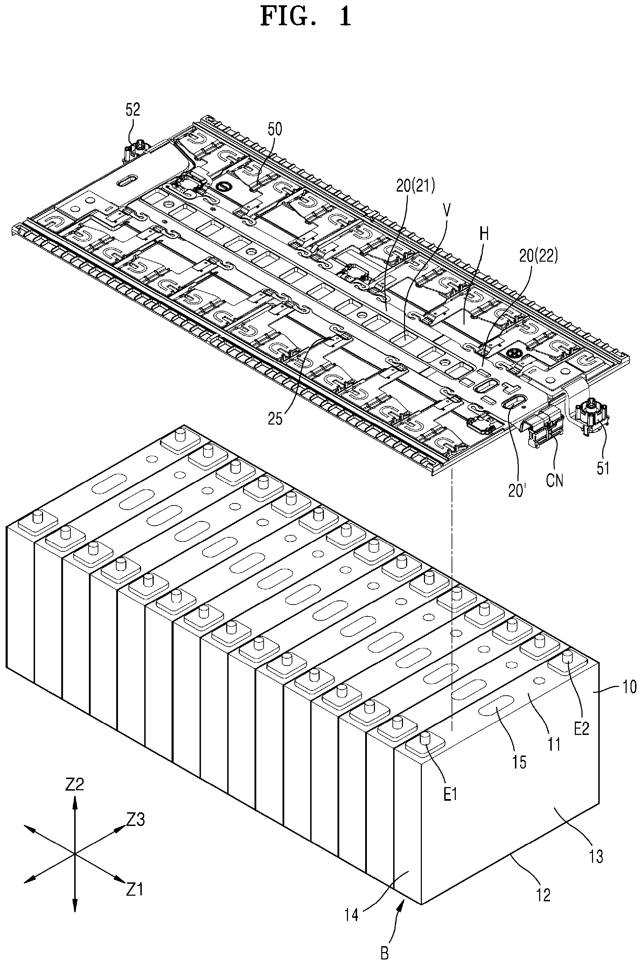

Hereinafter, a battery pack according to some embodiments of the present disclosure will be described with reference to FIGS. 1 to 5b.

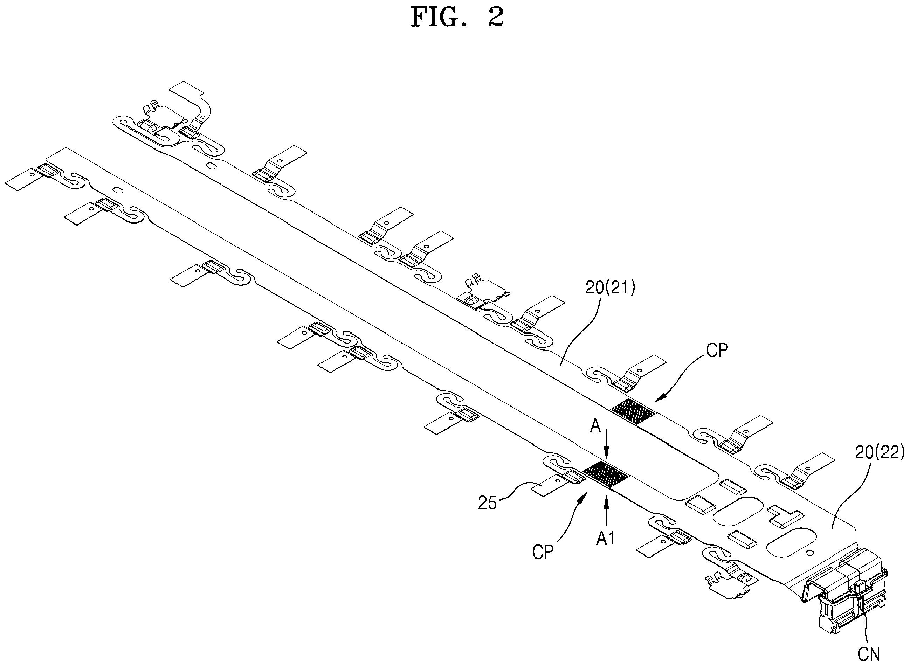

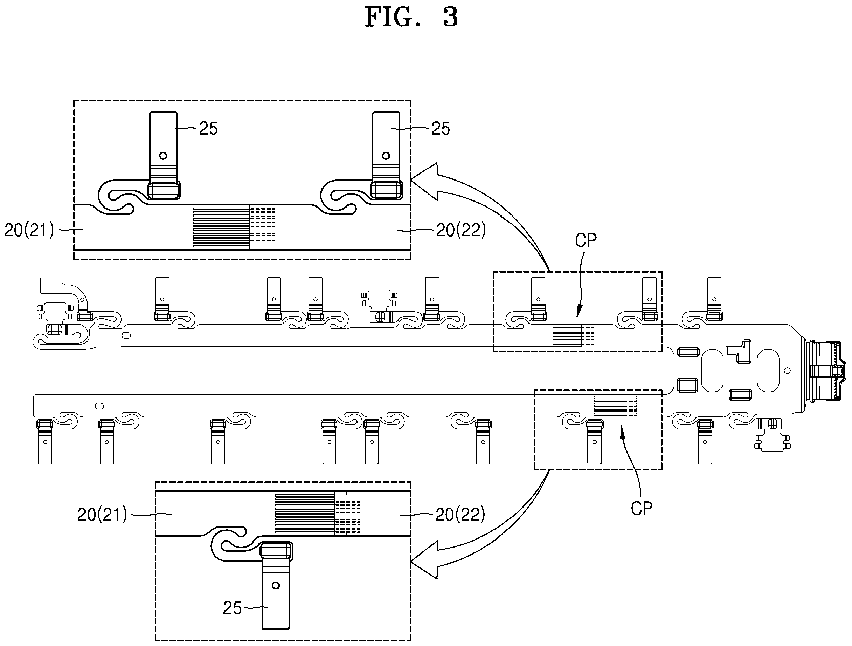

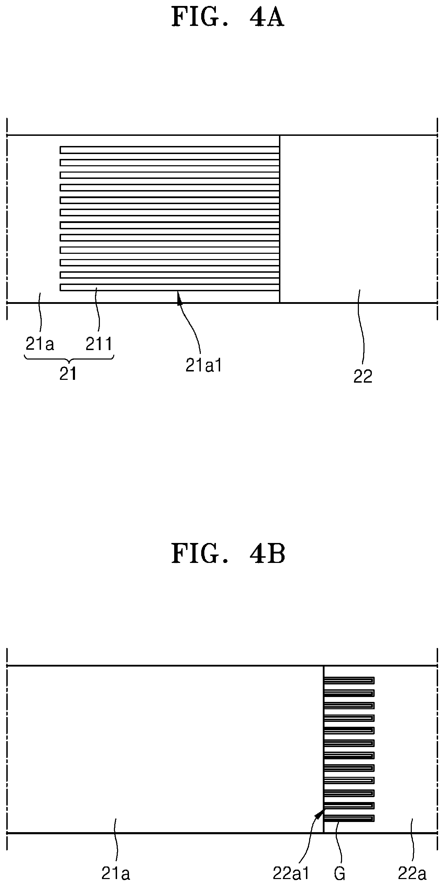

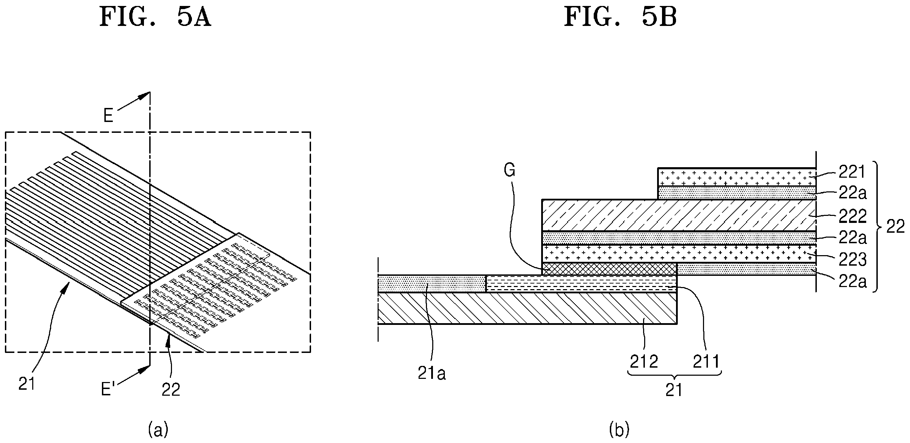

FIG. 1 shows an exposed perspective view of a battery pack according to some embodiments of the present disclosure. FIG. 2 is a schematic diagram showing a circuit board unit and a connector according to some embodiments of the present disclosure. FIG. 3 shows a front view of the circuit board unit of FIG. 2. FIG. 4a shows a view of the circuit board unit of FIG. 2 in a direction A. FIG. 4b shows a view of the circuit board unit of FIG. 2 in a direction A1. FIG. 5a shows a perspective view of a connection portion of FIG. 3. FIG. 5b shows a cross-sectional view of the connection portion of FIG. 3 taken along line E-E' of FIG. 5a.

Referring to FIG. 1, the battery pack according to some embodiments of the present disclosure may include a plurality of battery cells B arranged in a first direction Z1 and may include a bus bar 50 arranged over the plurality of battery cells B to electrically connect different battery cells B to each other.

Also, a bus bar holder H may be arranged between the bus bar 50 and the battery cell B for electrical insulation therebetween and for alignment of the assembly position of the bus bar 50. Together with the bus bar 50, a circuit board unit 20 for collecting state information of the battery cell B may be arranged over the bus bar holder H.

In some embodiments of the present disclosure, the bus bar 50 may be connected to first and second electrode terminals E1 and E2 having different polarities and arranged on a terminal surface 11 of the battery cell B in a third direction Z3 intersecting with the first direction Z1 in which the plurality of battery cells B are arranged. The first and second electrode terminals E1 and E2 may form first and second rows of electrode terminals E1 and E2 in the first direction Z1 in which the plurality of battery cells B may be arranged, and the bus bar 50 electrically connected to the first and second rows of electrode terminals E1 and E2 may form first and second rows of bus bars 50 over the first and second rows of electrode terminals E1 and E2.

Also, the circuit board unit 20 for collecting state information of the plurality of battery cells B may be arranged between the first and second rows of electrode terminals E1 and E2 or between the first and second rows of bus bars 50.

In an implementation, the first and second rows of bus bars 50 and the circuit board unit 20 arranged between the first and second rows of bus bars 50 may be supported together over the bus bar holder H and may be arranged over the bus bar holder H such that the assembly position thereof may be aligned and the insulation thereof from the battery cell B may be secured.

The battery cell B may include a terminal surface 11 on which the first and second electrode terminals E1 and E2 may be formed, a bottom surface 12 opposite to the terminal surface 11, and a wide side surface 13 occupying a relatively great area and a narrow side surface 14 occupying a relatively small area, as side surfaces 13 and 14 connecting the terminal surface 11 and the bottom surface 12 to each other. In an implementation, the plurality of battery cells B arranged in the first direction Z1 may be arranged such that the wide side surfaces 13 thereof face each other.

A vent portion 15 for reducing the internal pressure of the battery cell B may be formed over the terminal surface 11 of the battery cell B between the first and second electrode terminals E1 and E2 having different polarities, and vent holes V and 20' for allowing the flow of exhaust gas discharged through the vent portion 15 of the battery cell B may be respectively formed in the bus bar holder H and the circuit board unit 20 arranged over the vent portion 15. A connector CN electrically connected to the circuit board unit 20 may be formed at one end of the circuit board unit 20, and an electrical connection between the circuit board unit 20 and a battery manager may be formed through the connector CN.

In some embodiments of the present disclosure, in addition to the vent hole V, an opening portion for exposing a sensor 25 including a connection portion of the circuit board unit 20 toward the terminal surface 11 of the battery cell B may be formed in the bus bar holder H.

The bus bar 50 may electrically connect different battery cells B to each other, and a plurality of bus bars 50 electrically connected to each other may be electrically connected to an external device through input/output terminals 51 and 52. In the electrical connection of the plurality of battery cells B electrically connected to each other through the bus bar 50, the input/output terminals 51 and 52 may include a pair of different input/output terminals 51 and 52 connected to the battery cell B of one end position and the other end position or to the bus bar 50 connected to the battery cell B of one end position and the other end position.

The external device to which the plurality of battery cells B may be connected through the input/output terminals 51 and 52 may correspond to an external load receiving discharge power from the battery pack or an external charger supplying charge power to the battery pack.

The circuit board unit 20 may include first and second circuit board units 21 and 22 forming the body of the circuit board unit 20 and a plurality of sensors 25 branched toward different battery cells B from the first and second circuit board units 21and 22 of the circuit board unit 20. The second circuit board unit 22 may be coupled to the connector CN. The first circuit board unit 21 may be coupled to the second circuit board unit 22. Thus, information about the battery cell sensed through the first circuit board unit 21 may be transmitted to the connector CN through the second circuit board unit 22.

In some embodiments of the present disclosure, the sensor 25 of the circuit board unit 20 may extend along a meander shape from the first and second circuit board units 21 and 22 of the circuit board unit 20, and the sensor 25 of the circuit board unit 20 may extend along a meander shape to flexibly follow the displacement of the battery cell B following the first direction Z1 according to the expansion and contraction of the battery cell B.

The battery pack according to some embodiments of the present disclosure may include a plurality of battery cells B, and a state information transmission path for transmitting state information of the plurality of battery cells B, the state information transmission path including a first circuit board unit 21 including a first film layer 212 and a first conductive layer 211 formed over the first film layer 212, a second circuit board unit 22 including a second film layer 222 and a (2-1)^{th} conductive layer 221 and a (2-2)^{th} conductive layer 223 formed on different surfaces of the second film layer 222, and a conductive adhesive layer G arranged between the first circuit board unit 21 and the second circuit board unit 22 to form an electrical connection therebetween.

In some embodiments, the first conductive layer 211, the (2-1)^{th} conductive layer 221, and the (2-2)^{th} conductive layer 223 may each include copper. The conductive adhesive layer G may include a conductive adhesive (conductive glue). Thus, the conductive adhesive layer G may bond the first circuit board unit 21 and the second circuit board unit 22 to each other and simultaneously form an electrical connection between the first and second circuit board units 21 and 22 through a conductive adhesive component.

Referring to FIG. 5b, in the electrical connection direction of the first circuit board unit 21 and the second circuit board unit 22, the conductive adhesive layer G may be arranged between the first conductive layer 211 and the (2-2)^{th} conductive layer 223. Based on this, an electrical connection may be formed between the first conductive layer 211 and the (2-2)^{th} conductive layer 223. The electrical connection direction may correspond to the stacking direction of the layers of the first circuit board unit 21 and the second circuit board unit 22.

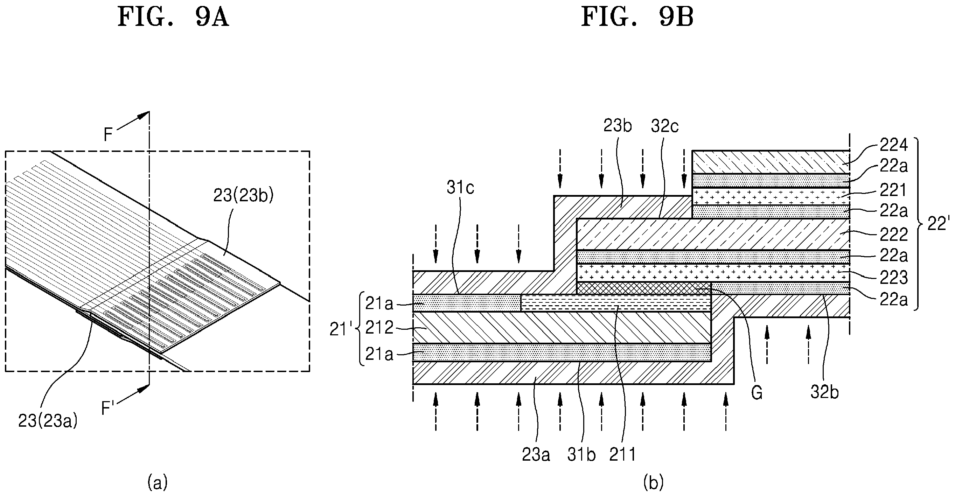

The second film layer 222 may be formed on one side surface of the (2-1)^{th} conductive layer 221, and a third film layer 224 (see FIG. 9b) may be formed on the other side surface of the (2-1)^{th} conductive layer 221. In other words, the second film layer 222 may be formed on one side surface of the (2-1)^{th} conductive layer 221, and a third film layer 224 (see FIG. 9b) may be formed on the opposing side surface of the (2-1)^{th} conductive layer 221. The first film layer 212, the second film layer 222, and the third film layer 224 (see FIG. 9b) may include a polyimide film.

According to the present embodiment, the (2-2)^{th} conductive layer 223 and the second film layer 222 may be formed to protrude more than the (2-1)^{th} conductive layer 221 and the third film layer 224 (see FIG. 9b) in a direction in which the first circuit board unit 21 is located. The direction in which the (2-2)^{th} conductive layer 223 and the second film layer 222 may protrude towards the first circuit board unit 21' is orthogonal with the stacking direction of the layers of the second circuit board unit 22'. Thus, the (2-2)^{th} conductive layer 223 and the second film layer 222 may form a step with the (2-1)^{th} conductive layer 221 and the third film layer 224 (see FIG. 9b). In other words, the (2-1)^{th} conductive layer 221 and the third film layer 224 may partially overlay the surface of the second film layer 222, wherein the surface of the second film layer 222 which is not overlaid with the (2-1)^{th} conductive layer 221 and the third film layer 224 may be closest to the first circuit board unit 21'.

According to the present embodiment, the first film layer 212 may include a first cover unit 21a covering the first film layer 212 from an external space, the first cover unit 21a may include a first recess portion 21a1 formed with a lengthwise direction corresponding to a direction parallel to the electrical connection direction of the first circuit board unit 21 and the second circuit board unit 22, and the first conductive layer 211 may be accommodated in the first recess portion 21a1 of the first cover unit 21a. For all embodiments, the electrical connection direction may be the direction of current flow between the first and second circuit boards 21, 22. In the plane view of Fig. 4a and 4b, this electrical connection direction is parallel to the lengthwise direction. For instance, in embodiments, the first and second circuit boards 21, 22 may be stacked on top of each other. While in this case a mechanical connection is formed orthogonal to the lengthwise direction in Figs. 4a and 4b, the net current flow in a plane view is still parallel to the lengthwise direction. In other words, the first circuit board unit 21 may include a first cover unit 21a, which may be disposed directly on the first film layer 212 and may be disposed adjacent to the first conductive layer 211, which may also be disposed directly on the first film layer 212.

Referring to FIG. 5b, the (2-1)^{th} conductive layer 221 and a second cover unit 22a contacting the (2-1)^{th} conductive layer 221 may form a first coverlay unit. In some embodiments, the second cover unit 22a may have a structure coated with a thermosetting epoxy adhesive.

Referring to FIG. 5b, a portion where the second film layer 222, the second cover unit 22a, the (2-2)^{th} conductive layer 223, and the second cover unit 22a may be sequentially stacked may form a flexible copper clad laminate (FCCL).

Referring to FIG. 4a, the first recess portion 21a1 may be formed in a shape in which a plurality of recess portions formed with a lengthwise direction corresponding to a direction parallel to the electrical connection direction of the first circuit board unit 21 and the second circuit board unit 22 may be arranged at equal intervals from each other.

Also, referring to FIG. 4b, the (2-2)^{th} conductive layer 223 may include a second cover unit 22a covering the (2-2)^{th} conductive layer 223 from an external space, the second cover unit 22a may include a second recess portion 22a1 formed with a lengthwise direction corresponding to a direction parallel to the electrical connection direction of the first circuit board unit 21 and the second circuit board unit 22, and the conductive adhesive layer G may be accommodated in the second recess portion 22a1 of the second cover unit 22a. In other words, the second circuit board unit 22 may include a second cover unit 22a, which may be disposed directly on the (2-2)^{th} conductive layer 223 and may be disposed adjacent to the conductive adhesive layer G, which may also be disposed directly on the (2-2)^{th} conductive layer 223.

As in the present embodiment, through the connection structure of the first and second circuit board units 21 and 22, the connection between the circuit board units may be possible regardless of the structure and type of the connector.

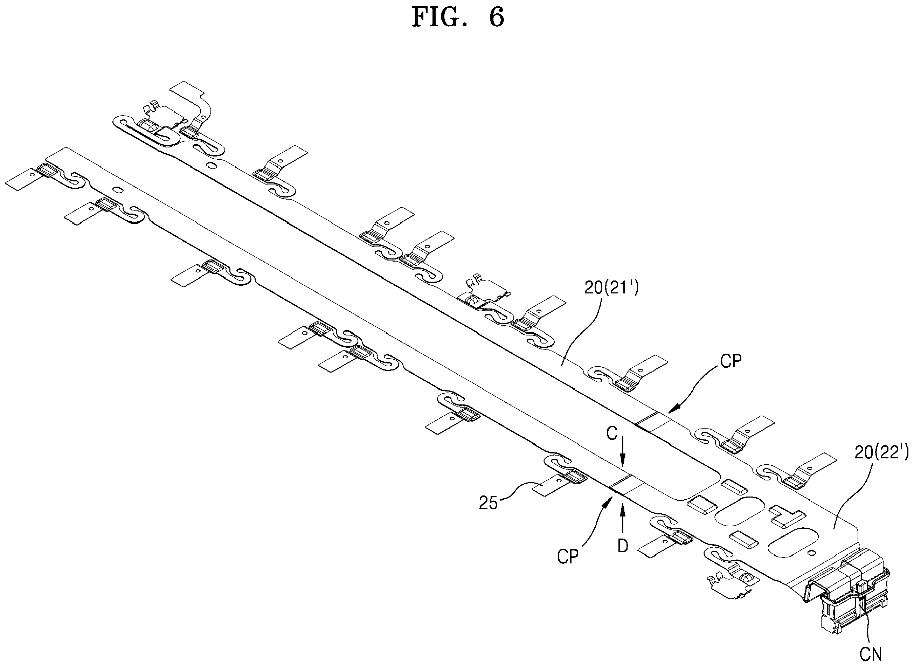

Hereinafter, a battery pack according to other embodiments of the present disclosure will be described with reference to FIGS. 6 to 9b. Descriptions not given with reference to FIGS. 6 to 9b may be the same as those given above with reference to FIGS. 1 to 5b.

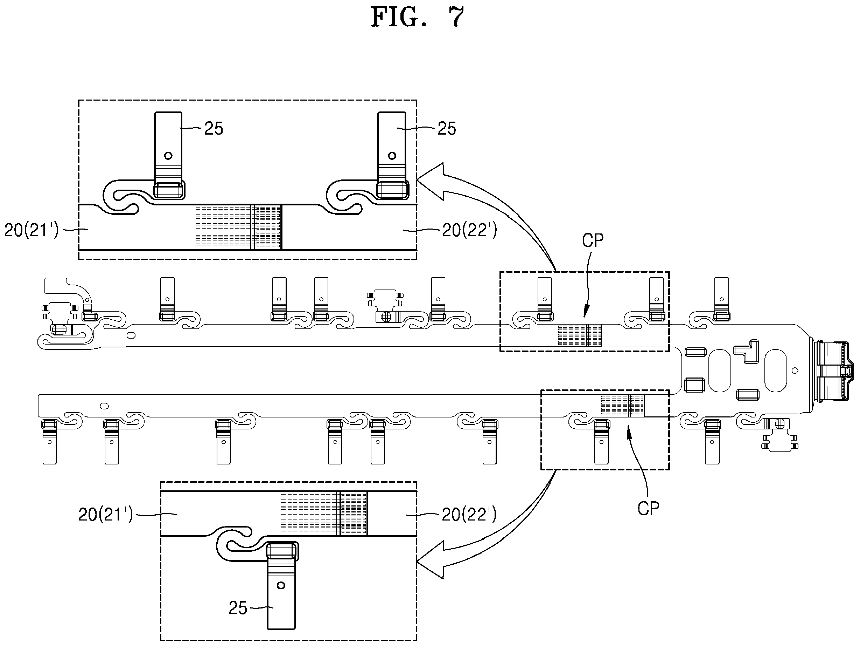

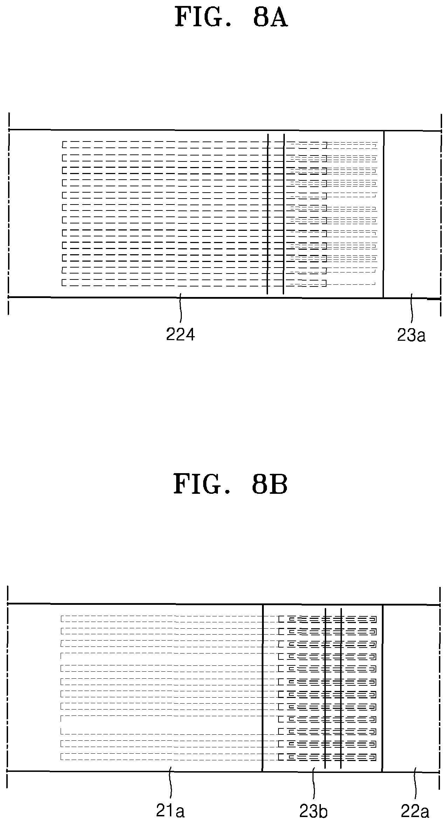

FIG. 6 shows a schematic diagram of a circuit board unit and a connector according to other embodiments of the present disclosure. FIG. 7 shows a front view of the circuit board unit of FIG. 6. FIG. 8a shows a view of the circuit board unit of FIG. 6 in a direction C. FIG. 8b shows a view of the circuit board unit of FIG. 6 in a direction D. FIG. 9a shows a perspective view of a connection portion of FIG. 7. FIG. 9b shows a cross-sectional view of the connection portion of FIG. 7 taken along line F-F' of FIG. 9a.

Referring to FIGS. 6 to 9b, the battery pack according to other embodiments of the present disclosure may include a plurality of battery cells B, and a state information transmission path for transmitting state information of the plurality of battery cells B, the state information transmission path including a first circuit board unit 21' including a first film layer 212 and a first conductive layer 211 formed over the first film layer 212, a second circuit board unit 22' including a second film layer 222 and a (2-1)^{th} conductive layer 221 and a (2-2)^{th} conductive layer 223 formed on different surfaces of the second film layer 222, a conductive adhesive layer G arranged between the first circuit board unit 21' and the second circuit board unit 22' to form an electrical connection therebetween, a first coating layer 23a covering a longitudinal section of the first circuit board unit 21' and a (1-1)^{th} step surface 31b of the first circuit board unit 21' and a (2-1)^{th} step surface 32b of the second circuit board unit 22' stepped from each other through the longitudinal section of the first circuit board unit 21', and a second coating layer 23b covering a longitudinal section of the second circuit board unit 22' and a (1-2)^{th} step surface 31c of the first circuit board unit 21' and a (2-2)^{th} step surface 32c of the second circuit board unit 22' stepped from each other through the longitudinal section of the second circuit board unit 22'.

In some embodiments, the first conductive layer 211, the (2-1)^{th} conductive layer 221, and the (2-2)^{th} conductive layer 223 may include copper. The conductive adhesive layer G may include a conductive adhesive (conductive glue). Thus, the conductive adhesive layer G may bond the first circuit board unit 21' and the second circuit board unit 22' to each other and simultaneously form an electrical connection between the first and second circuit board units 21' and 22' through a conductive adhesive component.

Referring to FIG. 9b, in the electrical connection direction of the first circuit board unit 21' and the second circuit board unit 22', the conductive adhesive layer G may be arranged between the first conductive layer 211 and the (2-2)^{th} conductive layer 223. Based on this, an electrical connection may be formed between the first conductive layer 211 and the (2-2)^{th} conductive layer 223.

The second film layer 222 may be formed on one side surface of the (2-1)^{th} conductive layer 221, and a third film layer 224 may be formed on the other side surface of the (2-1)^{th} conductive layer 221. The first film layer 212, the second film layer 222, and the third film layer 224 may include a polyimide film.

According to the present embodiment, the (2-2)^{th} conductive layer 223 and the second film layer 222 be formed to protrude more than the (2-1)^{th} conductive layer 221 and the third film layer 224 in a direction in which the first circuit board unit 21' is located.

According to the present embodiment, the first film layer 212 may include a first cover unit 21a covering the first film layer 212 from an external space, the first cover unit 21a may include a first recess portion 21a1 formed with a lengthwise direction corresponding to a direction parallel to the electrical connection direction of the first circuit board unit 21' and the second circuit board unit 22', and the first conductive layer 211 may be accommodated in the first recess portion 21a1 of the first cover unit 21a.

Referring to FIG. 9b, the second coating layer 23b and the first cover unit 21a contacting the second coating layer 23b may form a second coverlay unit. In some embodiments, the first cover unit 21a may have a structure coated with a thermosetting epoxy adhesive.

Referring to FIG. 9b, the first coating layer 23a and the first cover unit 21a contacting the first coating layer 23a may form a third coverlay unit. In some embodiments, the first cover unit 21a may have a structure coated with a thermosetting epoxy adhesive.

Referring to FIG. 9b, the third film layer 224 and a second cover unit 22a contacting the third film layer 224 may form a fifth coverlay unit. In some embodiments, the second cover unit 22a may have a structure coated with a thermosetting epoxy adhesive.

Referring to FIG. 9b, the first coating layer 23a and the second cover unit 22a contacting the first coating layer 23a may form a fourth coverlay unit. In some embodiments, the second cover unit 22a may have a structure coated with a thermosetting epoxy adhesive.

Referring to FIG. 9b, a portion where the (2-1)^{th} conductive layer 221, the second cover unit 22a, the second film layer 222, the second cover unit 22a, and the (2-2)^{th} conductive layer 223 may be sequentially stacked may form a flexible copper clad laminate (FCCL).

Referring to FIG. 4a, the first recess portion 21a1 may be formed in a shape in which a plurality of recess portions formed with a lengthwise direction corresponding to a direction parallel to the electrical connection direction of the first circuit board unit 21' and the second circuit board unit 22' may be arranged at equal intervals from each other.

Also, referring to FIG. 4b, the (2-2)^{th} conductive layer 223 may include a second cover unit 22a covering the (2-2)^{th} conductive layer 223 from an external space, the second cover unit 22a may include a second recess portion 22a1 formed with a lengthwise direction corresponding to a direction parallel to the electrical connection direction of the first circuit board unit 21' and the second circuit board unit 22', and the conductive adhesive layer G may be accommodated in the second recess portion 22a1 of the second cover unit 22a.

As in the present embodiment, through the connection structure of the first and second circuit board units 21' and 22', the connection between the circuit board units may be possible regardless of the structure and type of the connector.

According to the present embodiment, because the first and second coating layers 23a and 23b may be formed to cover the region of the conductive adhesive layer G to which the first and second circuit board units 21' and 22' may be connected and the step surfaces of the first and second circuit board units 21' and 22', the physical rigidity at a connection portion CP of the first and second circuit board units 21' and 22' may be secured.

Also, because the first and second coating layers 23a and 23b may include a polyimide film and may have insulation through the polyimide film, additional coating for securing electrical insulation may be unnecessary and the insulation of the connection portion CP may be sufficiently secured by the first and second coating layers 23a and 23b alone.

Also, the moisture resistance of the connection portion CP may be secured by preventing moisture from penetrating into the connection portion CP through the first and second coating layers 23a and 23b.

Also, the conductive adhesive layer G and the first and second coating layers 23a and 23b may be formed through a single lamination process. In an implementation, because a thermal compression process may be performed on the region of the conductive adhesive layer G to which the first and second circuit board units 21' and 22' may be connected, the first and second coating layers 23a and 23b forming the outermost portion of the connection portion CP, the first and second circuit board units 21' and 22' formed inside the first and second coating layers 23a and 23b, and the conductive adhesive layer G for coupling the first and second circuit board units 21' and 22' may be electrically and physically coupled to each other. Thus, a soldering process for connecting the circuit board units through a conductive adhesive may be unnecessary, and a separate coating process for attaching the first and second coating layers 23a and 23b to the first and second circuit board units 21' and 22' through a laminating process may also be unnecessary. Thus, because the coating process and the soldering process may be replaced by only a single laminating process, the manufacture of the connector (CP) structure may be simplified and thus the production of battery pack products may be improved.

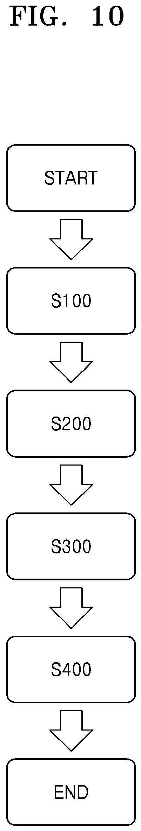

Hereinafter, a method of manufacturing a battery pack according to some embodiments of the present disclosure will be described. FIG. 10 is a flowchart showing a method of manufacturing a battery pack according to some embodiments of the present disclosure.

Referring to FIGS. 9b and 10, a method of manufacturing a battery pack according to the present embodiment may include an operation of arranging a conductive adhesive layer between a first circuit board unit including a first film layer and a first conductive layer formed over the first film layer and a second circuit board unit including a second film layer and a (2-1)^{th} conductive layer and a (2-2)^{th} conductive layer formed on different surfaces of the second film layer (S 100), an operation of stacking, on the first and second circuit board units, a first coating layer covering a longitudinal section of the first circuit board unit and a (1-1)^{th} step surface of the first circuit board unit and a (2-1)^{th} step surface of the second circuit board unit stepped from each other through the longitudinal section of the first circuit board unit (S200), an operation of stacking on the first and second circuit board units, a second coating layer covering a longitudinal section of the second circuit board unit and a (1-2)^{th} step surface of the first circuit board unit and a (2-2)^{th} step surface of the second circuit board unit stepped from each other through the longitudinal section of the second circuit board unit (S300), and an operation of thermally compressing the first and second circuit board units, the conductive adhesive layer, and the first and second coating layers through a laminating process (S400).

As such, because a connection portion having electrical insulation and physical rigidity may be manufactured through only a simple manufacturing process of arranging a conductive adhesive layer between first and second circuit board units, arranging first and second coating layers at the outermost surface portion of the first and second circuit board units, and then performing a lamination process through thermal compression, the production of the battery pack according to the present embodiment may be improved.

As such, the present disclosure has been described with reference to the embodiments illustrated in the drawings; however, this is merely an example. Those of ordinary skill in the art may fully understand that various modifications and other equivalent embodiments are possible from the described embodiments. Thus, the true scope of the present disclosure should be determined based on the appended claims.

Particular details described in the embodiments are merely examples and are not intended to limit the scope of the embodiments. In order to briefly and clearly describe the present disclosure, descriptions of general technologies and configurations of the related art may be omitted for conciseness.

Also, the connection of lines or connection members between the components illustrated in the drawing is an example of functional connections and/or physical or logical connections, which may be represented as various replaceable or additional functional connections, physical connections, or logical connections in an actual device. Also, when there is no particular reference such as "essential" or "important", it may not necessarily be a component necessary for application of the present disclosure.

The term "the" or similar designators used in the description of the present disclosure and the claims may refer to both singular and plural unless otherwise specifically defined.

Also, when there is no clear or contrary description about the order of operations constituting the method according to embodiments, the operations may be performed in a suitable order.

In the battery pack and the battery pack manufacturing method according to some embodiments of the present disclosure, the first and second circuit board units may be connected regardless of the connector type.

Also, in the battery pack and the battery pack manufacturing method according to some embodiments of the present disclosure, the rigidity of the connection portion may be obtained through the lamination process between the first and second circuit board units.

Also, in the battery pack and the battery pack manufacturing method according to some embodiments of the present disclosure, the manufacturing process may be further simplified by substituting a single laminating process for a soldering process and a coating process generally used for bonding between circuit board units. Effects of the present disclosure are not limited to the effects described above, and other effects not described herein will be clearly understood by those of ordinary skill in the art from the description of the claims.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope of the present disclosure as defined by the following claims.

By way of summation and review, small mobile devices such as mobile phones may operate for a certain period of time with the power and capacity of a single battery. However, if long-period driving and high-power driving are required such as electric vehicles and hybrid vehicles with high power consumption, battery packs may be preferred due to the problems of power and capacity and the output voltage or output current of battery packs may be increased according to the number of battery cells embedded therein.

In general, as a component for transmitting state information of battery cells, a battery pack may include a connector for an electrical connection between a circuit board unit such as an FPC and a circuit unit collecting state information about the battery cells. However, depending on the type of the connector, the rigidity of a connection portion between the connector and the circuit board unit may vary, and also, the rigidity between the connector and the circuit board unit may degrade.

One or more embodiments of the present disclosure may include a battery pack and a method of manufacturing the battery pack, wherein a connection between FPCs is possible regardless of the connector type while the rigidity of a connection portion is secured.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A battery pack, comprising:
a plurality of battery cells; and
a state information transmission path for transmitting state information of the plurality of battery cells,
wherein the state information transmission path includes:
a first circuit board unit (21, 21') including a first film layer (212) and a first conductive layer (211) formed over the first film layer (212),
a second circuit board unit (22, 22') including a second film layer (222) and a (2-1)^{th} conductive layer (221) and a (2-2)^{th} conductive layer (223) formed on different surfaces of the second film layer (222),
a conductive adhesive layer (G) arranged between the first circuit board unit (21, 21') and the second circuit board unit (22, 22') to form an electrical connection therebetween,
a first coating layer (23a) covering a longitudinal section of the first circuit board unit (21, 21') and a (1-1)^{th} step surface (31b) of the first circuit board unit (21, 21') and a (2-1)^{th} step surface (32b) of the second circuit board unit (22, 22') stepped from each other through the longitudinal section of the first circuit board unit (21, 21'), and
a second coating layer (23b) covering a longitudinal section of the second circuit board unit (22, 22') and a (1-2)^{th} step surface (31c) of the first circuit board unit (21, 21') and a (2-2)^{th} step surface (32c) of the second circuit board unit (22, 22') stepped from each other through the longitudinal section of the second circuit board unit (22, 22').

2. The battery pack as claimed in claim 1, wherein the conductive adhesive layer (G) is arranged between the first conductive layer (211) and the (2-2)^{th} conductive layer (223) in an electrical connection direction of the first circuit board unit (21, 21') and the second circuit board unit (22, 22').

3. The battery pack as claimed in claim 1 or 2, wherein the second film layer (222) is formed on one side surface of the (2-1)^{th} conductive layer (221), and a third film layer (224) is formed on an other side surface of the (2-1)^{th} conductive layer (221).

4. The battery pack as claimed in claim 3, wherein the (2-2)^{th} conductive layer (223) and the second film layer (222) protrude more than the (2-1)^{th} conductive layer (221) and the third film layer (224) in a direction in which the first circuit board unit (21, 21') is located.

5. The battery pack as claimed in one of the preceding claims, wherein:
the first film layer (212) includes a first cover unit (21a) covering the first film layer (212) from an external space,
the first cover unit (21a) includes a first recess portion (21a1) formed with a lengthwise direction corresponding to a direction parallel to an electrical connection direction of the first circuit board unit (21, 2 1') and the second circuit board unit (22, 22'), and
the first conductive layer (211) is accommodated in the first recess portion (21a1) of the first cover unit (21a).

6. The battery pack as claimed in one of the preceding claims, wherein:
the (2-2)^{th} conductive layer (223) includes a second cover unit (22a) covering the (2-2)^{th} conductive layer (223) from an external space,
the second cover unit (22a) includes a second recess portion (22a1) formed with a lengthwise direction corresponding to a direction parallel to an electrical connection direction of the first circuit board unit (21, 2 1') and the second circuit board unit (22, 22'), and
the conductive adhesive layer is accommodated in the second recess portion (22a1) of the second cover unit (22a).

7. The battery pack as claimed in one of the preceding claims, wherein the conductive adhesive layer and the first and second coating layers (23a, 23b) are each formed through a single laminating process.

8. The battery pack as claimed in one of the preceding claims, wherein the first film layer (212) and the second film layer (222) include a polyimide film.

9. The battery pack as claimed in one of the preceding claims, wherein the first coating layer (23a) and the second coating layer (23b) include a polyimide film.

10. A method of manufacturing a battery pack, the method comprising:
arranging a conductive adhesive layer between a first circuit board unit (21, 21') including a first film layer (212) and a first conductive layer (211) formed over the first film layer (212) and a second circuit board unit (22, 22') including a second film layer (222) and a (2-1)^{th} conductive layer (221) and a (2-2)^{th} conductive layer (223) formed on different surfaces of the second film layer (222);
stacking, on the first and second circuit board units (21, 21', 22, 22'), a first coating layer (23a) covering a longitudinal section of the first circuit board unit (21, 21') and a (1-1)^{th} step surface (31b) of the first circuit board unit (21, 21') and a (2-1)^{th} step surface (32b) of the second circuit board unit (22, 22') stepped from each other through the longitudinal section of the first circuit board unit (21, 21');
stacking a second coating layer (23b) covering a longitudinal section of the second circuit board unit (22, 22') and a (1-2)^{th} step surface (31c) of the first circuit board unit (21, 21') and a (2-2)^{th} step surface (32c) of the second circuit board unit (22, 22') stepped from each other through the longitudinal section of the second circuit board unit (22, 22'); and
thermally compressing the first and second circuit board units (21, 21', 22, 22'), the conductive adhesive layer (G), and the first and second coating layers (23a, 23b) through a laminating process.

11. The method as claimed in claim 10, wherein the thermal compressing is performed on the region of the conductive adhesive layer (G) to which the first and second circuit board units 21' and 22' are connected, and with the first and second coating layers (23a, 23b) forming the outermost layers.
